Europäisches Patentamt

European Patent Office

Office européen des brevets

(11) Publication number: **0 273 574 B1**

# EUROPEAN PATENT SPECIFICATION

(45) Date of publication of patent specification: **11.09.91**  (51) Int. Cl.5: **G06F  1/00**, G06F 1/24

(21) Application number: **87310262.8**

(22) Date of filing: **20.11.87**

(54) Initial value setting system for an electronic device.

(30) Priority: **27.11.86 JP 282289/86**

(43) Date of publication of application:
**06.07.88 Bulletin  88/27**

(45) Publication of the grant of the patent:
**11.09.91 Bulletin  91/37**

(84) Designated Contracting States:
**DE FR GB**

(56) References cited:
**EP-A- 0 096 531**

**PATENT ABSTRACTS OF JAPAN, vol. 6, no. 211 (E-137)[1089], 23rd October 1983; & JP - A - 57 116 425 (TOKYO SHIBAURA DENKI K.K.) 20-07-1982**

(73) Proprietor: **SEIKO INSTRUMENTS INC.**
**31-1, Kameido 6-chome Koto-ku**
**Tokyo 136(JP)**

(72) Inventor: **Nakabayashi, Yasushi**
**Seiko Instruments Inc. 31-1 Kameido**
**6-chome**
**Koto-ku Tokyo(JP)**

(74) Representative: **Miller, Joseph et al**
**J. MILLER & CO. Lincoln House 296-302 High**
**Holborn**
**London WC1V 7JH(GB)**

**Description**

This invention relates to initial value setting systems for electronic devices, for example, comprising a RAM which stores information such as time data, a ROM which stores a program for operating various functions, and an LSI including a CPU for logical operation.

Various countermeasures to prevent malfunctioning of an electronic device by external disturbances have been employed in conventional electronic devices employing C-MOS LSI. In order to absorb surge-noise generated in a power source, a large capacitance may be connected with the power source. In order to absorb disturbance noise, the positional relationship between respective input/output terminals of the LSI and the power source are regulated, and capacitance elements are added between the input/output terminals and the power source.

When the power is turned on, it is necessary to set an initial value in order to operate electronic devices employing LSIs which include ROMs, RAMs and CPUs. The procedure for setting an initial value of, for example, electronic timepieces for storing data of initial values such as counting and storing functions for time data or other functions, includes setting an initial value in a ROM which stores the program for operating the various functions and, by executing the operation of initial value setting means, the data of the various functions stored in a RAM are initialised. Therefore, conventional electronic devices have had the disadvantage that an erroneous all-clear signal could be produced during normal operation when the initial value setting means was operated by an external disturbance. In addition, since it is only to decrease power source noise generated by the external disturbance that the above countermeasures were heretofore employed, such countermeasures could not work effectively.

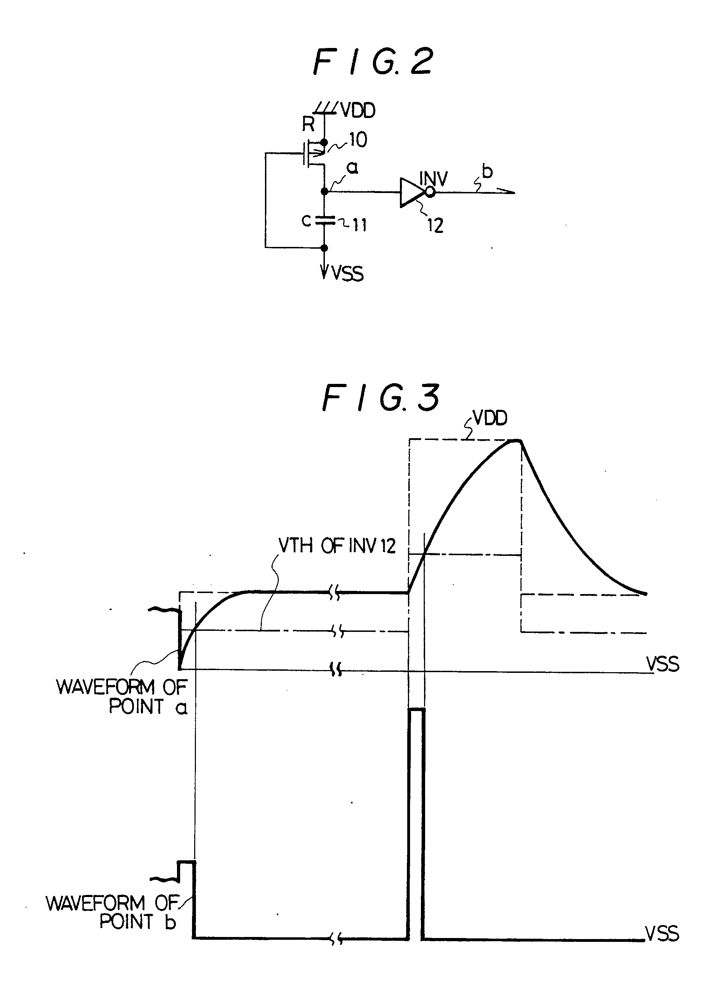

As one example of the prior art, the well-known operation of a power-on clear circuit during power source change will now be described. Figure 2 shows a typical example of a power-on clear circuit which comprises a resistor R composed of a P-channel transistor 10 whose source is connected to voltage VDD and whose gate is connected to a voltage VSS. A capacitor 11 with a capacitance C is connected in series with the resistor R, and an inverter (INV) 12 is connected to a centre tap point a between the capacitor 11 and the transistor 10.

Figure 3 is a timing chart which shows voltage waveforms at points a and b in response to changes in power source voltage VDD (indicated by a broken line) applied to the power-on clear circuit shown in Figure 2. A dash and dotted line in Figure 3 indicates changes of threshold voltage VTH (VTH = VDD/2) of the inverter 12 when changes occur in the power source voltage VDD. When power is inputted or changed, the voltage waveform at the point a between the capacitor 11 and the transistor 10 becomes a differential waveform as shown by a solid line in Figure 3, due to the charging characteristics of the capacitor 11. Since the threshold voltage VTH of the inverter 12 changes with change in the power source voltage, the inverter 12 outputs voltage VDD to the point b when the voltage at the point a is below the threshold voltage VTH. This results in an all-clear signal shown by a trigger pulse in the waveform of the voltage at point b.

Another arrangement for generating trigger pulses in response to fluctuations of the voltage level of a power source is disclosed in EP-A-0,096,531. In this arrangement, a power-supply-potential detecting circuit monitors the voltage level of the power source and generates a stepwise reset signal or trigger pulse whenever the voltage level falls below a predetermined value.

OBJECTS AND SUMMARY OF THE INVENTION

The present invention seeks to provide an initial value setting system which is capable of preventing an erroneous execution of an initialisation operation by providing means to discriminate whether or not an initial value setting means should be run. Therefore, if electrostatic disturbance is generated under normal operating conditions, the initial value setting means is not driven and erroneous production of an all-clear signal can be prevented.

Acoording to the present invention there is provided an initial value setting system for an electronic device, comprising system clearing means for generating trigger pulses in response to fluctuations of voltage level of a power source, and initial value setting means operable in response to the trigger pulses for undergoing an initialisation operation of the electronic device, characterised by counter means for counting during a time interval following the generation of a respective trigger pulse corresponding to an initial voltage level fluctuation and before the generation of a pre-determined subsequent trigger pulse the initial value setting means being operable for under going the initialisation operation when the total value counted by the counter means before the generation of the pre-determined subsequent trigger pulse is less than a pre-determined value.

Thus, the present invention distinguishes voltage fluctuations caused by power-on from voltage fluctuations caused by disturbance by the fact that in the case of the former a pre-determined subsequent trigger pulse is generated within a given time interval following generation of an initial pulse corresponding to power-on voltage fluctuation,

Preferably said system includes storing means for storing a value indicating the occurrence of the trigger pulses, and re-setting means operable to reset the content of the storing means after elapse of said time interval or upon the generation of a predetermined number of trigger pulses, which ever occurs first.

The invention is illustrated, merely by way of example, in the accompanying drawings, in which:-

Figure 1 is a block diagram illustrating an embodiment for an initial value setting system according to the present invention;

Figure 2 is a circuit diagram illustrating one example of a power-on clear circuit;

Figure 3 is a timing chart illustrating operation of the power-on clear circuit of Figure 2;

Figure 4 is a timing chart illustrating operation of an embodiment of an initial value setting circuit according to the present invention;

Figure 5 is a detailed block diagram illustrating a periphery of a CPU shown in Figure 1; and

Figure 6 is a flow chart of logical operation of an initial value setting circuit according to the present invention.

## DESCRIPTION OF A PREFERRED EMBODIMENT

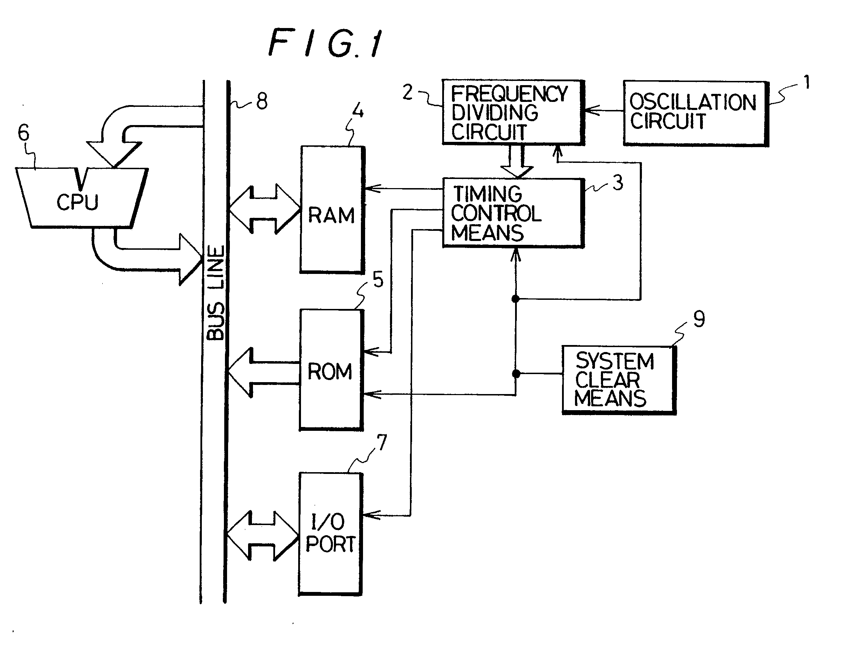

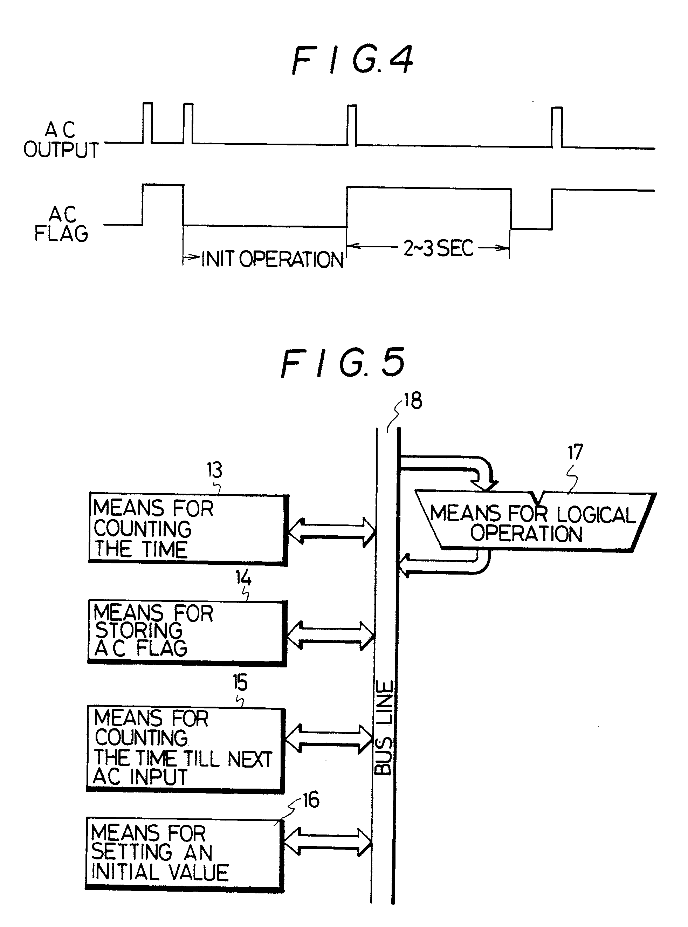

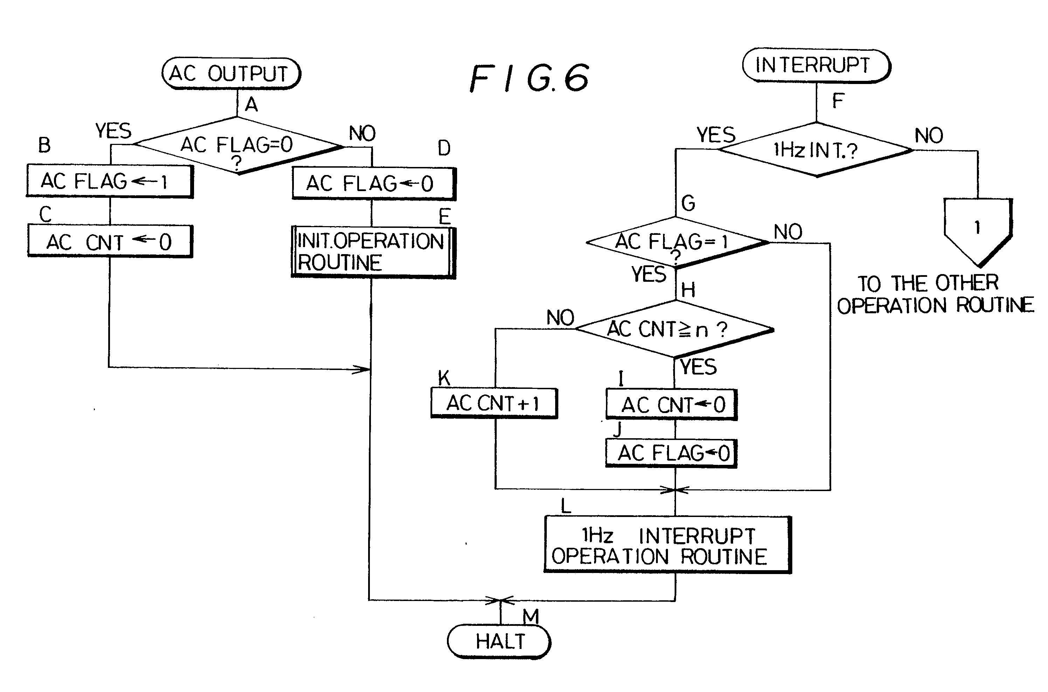

Figure 1 is a block diagram defining an embodiment of an initial value setting system according to the present invention applied to an electronic timepiece. An oscillation circuit 1 employs a quartz oscillator as a source of oscillation. A frequency dividing circuit 2 frequency divides the frequency of an output of the oscillation circuit 1. Timing control means 3 forms and produces timing clock signals necessary for operating the electronic timepiece in response to a plurality of outputs from the frequency dividing circuit 2. A RAM 4 counts and stores a plurality of time functions and time data. A ROM 5 stores program instructions whereby the operation procedure of the plurality of time functions and data is programmed. A CPU 6 is provided for arithmetical and logical operation. An I/O port 7 receives inputs from an external switch (not shown) and outputs time display information. A bus line 8 transfers data. A system means 9 generates a signal for initialising the condition of the frequency dividing circuit 2, the timing control means 3 and the ROM 5. Figure 4 is a timing chart illustrating an embodiment of the present invention, Figure 5 is a block diagram indicating in detail an area of the CPU 6 in Figure 1, and Figure 6 is a flow chart of the logical operation which is executed by the CPU 6 shown in Figure 5, and the instructions from the flow chart programmed and stored in the ROM 5.

The periphery of the CPU 6 of Figure 1 shown in Figure 5 comprises a means 13 for counting the time, a means 14 for storing an AC flag, a means 15 for counting the time until a next AC input, a means 16 for setting an initial value, and a means 17 for logical operation, these means being connected via a bus line 18.

Output signals of the system clear means 9 in Figure 1 is indicated on the timing chart of Figure 4 as an AC output. When the AC output is generated, data from the means 14 which stores the AC flag is read via the bus line 18, by the means 17 for logical operation, and discriminated whether it is "0" or "1". When the discriminated data is "0", the data is changed to "1" and is again written via the bus line 18, to the means 14 which stores the AC flag. Subsequently, the data of the means 15 which counts the time until the next AC input is read via the bus line 18, by the means 17 for logical operation, and the data is changed to "0" and is again written to the means 15 which counts the time till the next AC input. When the discriminated data is "1", by the means 17 for logical operation, "0" is written via the bus line 18 to the means 14 which stores the AC flag and according to the data of the means 16, an initial value is set over the entire system, via the bus line 18.

A signal formed by the timing control means 3 in Figure 1 gives an instruction to the system via the I/O port 7, to start an operation (generally called an "interrupt"). When the interrupt is 1Hz, the data of the means 14 which stores the AC flag is read by the means 17 for logical operation and discriminated whether it is "0" or "1". In the case of "0", the system is generally operated with 1Hz interrupt execution. In the case of "1", the data of the means 15 which counts the time till the next AC input is read via the bus line 18 and is discriminated by the means 17 for logical operation whether the data is equal to or larger than a predetermined time duration "n". When the thus discriminated result is "NO", "1" is added to the data of the means 15 which counts the time till the next AC input and, via the bus line 18, is written to the means 15. When the discriminated result is "YES", the data of the means 15 which counts the time till the next AC input and the data of the means 14 which stores the AC flag are written to the respective means 14,15, as the value of "0", via the bus line 18. Afterwards, the thus written value is operated with interrupt execution such as the means 13 which counts the time, and the operation returns to a HALT condition.

Figure 6 illustrates a flow chart showing execution of the above mentioned control operation, wherein symbols A to M denote each step for execution in the flow chart.

The control operation employed is executed when a trigger pulse or AC input is generated due to an external disturbance, noise or the like, or when interrupt occurs in intervals of 1Hz. When an AC output occurs under an interrupt-waiting condition (hereinafter referred to as a HALT condition), a step A discriminates if the AC flag is "0", at first. When the discriminated result if "YES", the program proceeds to a step B. When the discriminated result is "NO", the program proceeds to a step D. The value of "1" is written to the AC flag at the step B and, in a step C, the value of "0" is written to the means 15 which counts the time till the next AC input, and the operation returns to the HALT condition. The value of "0" is written to the AC flag at the step D, an initial operation routine for setting an initial value is executed at a step E, and the operation finally returns to the HALT condition.

In addition, if an interrupt occurs at intervals of 1Hz under the HALT condition, a step F discriminates whether it is a 1Hz interrupt or not. When the result is "YES", the program proceeds to a step G. When the result is "NO", the program proceeds to the other operation routine. The step G discriminates whether or not the AC flag is "1". When the result of the discrimination is "YES", the program proceeds to a step H and when the result is "NO", the program proceeds to step L which executes a 1Hz interrupt operation routine. The step H discriminates whether the data of the means 15 which counts the time till the next AC input is larger than or equal to the value "n". When the result is "YES", the program proceeds to a step I and when the result is "NO", the program proceeds to a step K. The step I sets the data of the means 15, which counts the time spent till the next AC input to "0", and also changes the AC flag to "0". The step K adds "1" to the data of the means 15 which counts the time spent till the next AC input, the step L executes the 1Hz interrupt operation routine, and the program returns to the HALT condition.

According to the present invention as described above, when, for example, there is an electrostatic disturbance the system clear means 9 operates due to a surge voltage caused on the power supply voltage. However, if a trigger pulse of an AC output is generated, the program is controlled not to execute the operation for setting an initial value. Therefore, the present invention has the effect of preventing erroneous production of an all-clear signal.

The described embodiment uses an AC flag of "0" or "1" but it is possible to prevent erroneous operation caused by an AC output which is successively produced, by increasing the number of bits of the AC flag. The time duration counted till the next AC input is specified as 2 to 3 seconds in Figure 4 but the time duration "n" may have any desired value.

## Claims

1. An initial value setting system for an electronic device, comprising system clearing means (9) for generating trigger pulses in response to fluctuations of voltage level of a power source, and initial value setting means (16) operable in response to the trigger pulses for undergoing an initialisation operation of the electronic device, characterised by counter means (15) for counting during a time interval following the generation of a respective trigger pulse corresponding to an initial voltage level fluctuation and before the generation of a pre-determined subsequent trigger pulse, the initial value setting means being operable for undergoing the initialisation operation when the total value counted by the counter means before the generation of the pre-determined subsequent trigger pulse is less than a pre-determined value.

2. An initial value setting system as claimed in claim 1, characterised by storing means (14) for storing a value indicating the occurrence of the trigger pulses, and re-setting means (17) operable to re-set the content of the storing means after elapse of said time interval or upon the generation of a pre-determined number of trigger pulses, which ever occurs first.

3. An initial value setting system as claimed in claim 1 or 2, characterised in that the pre-determined subsequent trigger pulse is the next trigger pulse.

## Revendications

1. Un système de fixation de valeur initiale pour un dispositif électronique, comprenant des moyens de remise à zéro de système (9) qui sont destinés à générer des impulsions de déclenchement sous l'effet de fluctuations du niveau de tension d'une source d'énergie, et des moyens de fixation de valeur initiale (16), qui peuvent fonctionner sous la dépendance des impulsions de déclenchement de façon à accomplir une opération d'initialisation du dispositif électronique, caractérisé par des moyens de comptage (15) qui sont destinés à compter pendant un intervalle de temps qui suit la génération d'une impulsion de déclenchement respective correspondant à une fluctuation de niveau de tension initiale, et qui précède la génération d'une impulsion de déclenchement suivante prédéterminée, les moyens de fixation de valeur initiale pouvant être actionnés de façon à accomplir l'opération d'initialisation lorsque la valeur totale qui est comptée par les moyens de comptage avant la génération de l'impulsion de déclenchement suivante prédéterminée, est inférieure à une valeur prédéterminée.

2. Un système de fixation de valeur initiale selon la revendication 1, caractérisé par des moyens d'enregistrement (14) qui sont destinés à enregistrer une valeur indiquant l'apparition des impulsions de déclenchement, et par des moyens de restauration (17) que l'on peut actionner de façon à restaurer le contenu des moyens d'enregistrement après l'écoulement de l'intervalle de temps prédéterminé, ou au moment de la génération d'un nombre d'impulsions de déclenchement prédéterminé, l'événement qui est pris en compte étant celui qui se produit en premier.

3. Un système de fixation de valeur initiale selon la revendication 1 ou 2, caractérisé en ce que l'impulsion de déclenchement suivante prédéterminée est l'impulsion de déclenchement immédiatement suivante.

**Patentansprüche**

1. System zum Setzen von Startwerten für ein elektronisches Gerät, mit Mitteln (9), die auf Fluktuationen des Spannungspegels einer Spannungsquelle ansprechend Triggerimpulse erzeugen, und mit Startwertsetzmitteln (16), die auf die Triggerimpulse ansprechend einen Initialisierungsvorgang des elektronischen Gerätes durchführen können. **gekennzeichnet** durch Zählermittel (15) zur Zählung während eines Zeitintervalls, das der Erzeugung eines jeweiligen mit einer anfänglichen Spannungspegelfluktuation korrespondierenden Triggerimpulses folgt, und vor der Erzeugung eines vorbestimmten nachfolgenden Triggerimpulses, wobei die Startwertsetzmittel den Initialisierungsvorgang durchführen können, wenn der von den Zählermitteln vor der Erzeugung des vorbestimmten nachfolgenden Triggerimpulses gezählte Summenwert kleiner als ein vorbestimmter Wert ist.

2. System zum Setzen von Startwerten nach Anspruch 1, **gekennzeichnet** durch Speichermittel (14) zur Speicherung eines Wertes, der das Auftreten der Triggerimpulse indiziert, und durch Rücksetzmittel (17), die den Inhalt der Speichermittel löschen, nachdem das Zeitintervall abgelaufen ist oder nach Auftreten einer vorbestimmten Anzahl von Triggerimpulsen, jenachdem welches dieser Ereignisse zuerst eintritt.

3. System zum Setzen von Startwerten nach Anspruch 1 oder 2, **dadurch gekennzeichnet,** daß der vorbestimmte nachfolgende Triggerimpuls der nächste Triggerimpuls ist.

# F I G. 1

OSCILLATION CIRCUIT — 1

FREQUENCY DIVIDING CIRCUIT — 2

TIMING CONTROL MEANS — 3

SYSTEM CLEAR MEANS — 9

CPU — 6

BUS LINE — 8

RAM — 4

ROM — 5

I/O PORT — 7

EP 0 273 574 B1

# F I G. 2

# F I G. 3

VDD

VTH OF INV 12

VSS

WAVEFORM OF
POINT a

WAVEFORM OF
POINT b

VSS

# F I G. 4

AC OUTPUT

AC FLAG

←INIT OPERATION    ←2~3 SEC→

# F I G. 5

18

13

| MEANS FOR COUNTING THE TIME |

17

MEANS FOR LOGICAL OPERATION

14

| MEANS FOR STORING AC FLAG |

15

| MEANS FOR COUNTING THE TIME TILL NEXT AC INPUT |

BUS LINE

16

| MEANS FOR SETTING AN INITIAL VALUE |

8

FIG.6

AC OUTPUT

A — AC FLAG = 0 ?
YES → B AC FLAG ← 1 → C AC CNT ← 0
NO → D AC FLAG ← 0 → E INIT.OPERATION ROUTINE

INTERRUPT

F — 1Hz INT. ?
NO → 1
YES → G AC FLAG = 1 ?
NO → TO THE OTHER OPERATION ROUTINE
YES → H AC CNT ≥ n ?
NO → K AC CNT + 1
YES → I AC CNT ← 0 → J AC FLAG ← 0 → L 1Hz INTERRUPT OPERATION ROUTINE

M HALT